(19) Europäisches Patentamt / European Patent Office / Office européen des brevets

(11) **EP 2 621 084 A1**

(12) **EUROPEAN PATENT APPLICATION**

(43) Date of publication:
**31.07.2013 Bulletin 2013/31**

(51) Int Cl.:
**H03F 1/02** (2006.01)

(21) Application number: **12425015.0**

(22) Date of filing: **24.01.2012**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **System Engineering Solutions S.r.l.
20851 Lissone (MB) (IT)**

(72) Inventor: **Carcano, Marco
20030 Senago (Prov. di Milano) (IT)**

(74) Representative: **Modiano, Micaela Nadia et al
Modiano & Partners (IT)
Via Meravigli, 16
20123 Milano (IT)**

Remarks:
Amended claims in accordance with Rule 137(2) EPC.

(54) **Power amplifier with modified doherty topology**

(57) A power amplifier with a modified Doherty topology (1) adapted to drive a load (4), comprising a main circuit (2) in turn comprising a main amplifier (20), and an auxiliary circuit (3) in turn comprising an auxiliary amplifier (30), comprising moreover a circuit (5) with paired transmission lines (57, 58) which is adapted to connect the main circuit (2) to the auxiliary circuit (3).

Fig. 8

EP 2 621 084 A1

**Description**

The present invention relates to a power amplifier with a modified Doherty topology.

In current telecommunications systems the use is known of radiofrequency and microwave power amplifiers for which it is very important to ensure high efficiency thus limiting distortion and nonlinearity of the outgoing signals.

Nowadays the signals that have to be transmitted and amplified are often signals with a complex envelope, typically digitally modulated, characterized by a high dynamic, in terms of the ratio between the peak envelope power and the average bolometric power.

For such signals, in order to obtain a good compromise between linearity and efficiency, the use is known of class-AB power amplifiers, i.e. class-B amplifiers, with a slight polarization of current that is adapted to optimize the linearity of the power output.

AB-class amplifiers ensure good efficiency, in terms of the ratio between the average bolometric radiofrequency power output and the power absorbed by the power supply, only for unmodulated signals with power proximate to the maximum power that can be output by the amplifier. For signals of lower power than the maximum power that can be output, the efficiency drops drastically, as with signals modulated with a complex envelope, such as digital modulation, with an average bolometric power much lower than the peak power of the signal, the efficiency of the amplifier is much lower than the optimal value, causing considerable increases in electricity consumption.

In order to considerably increase the efficiency of radiofrequency and microwave amplifiers, the type of amplification known as Doherty is widely used.

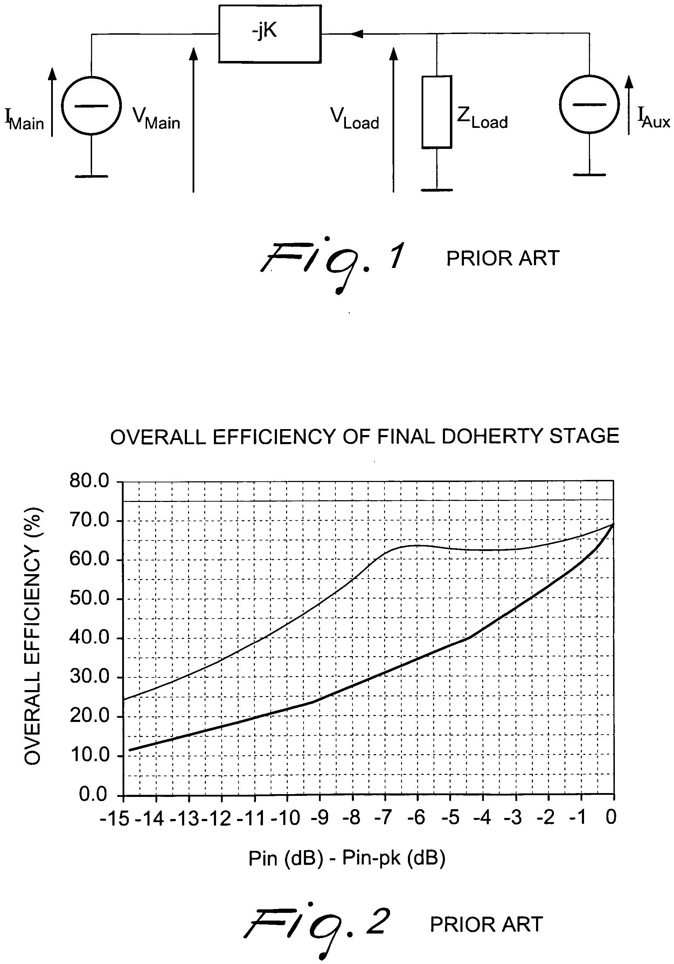

Figure 1 is a schematic diagram of a power amplifier with Doherty topology. In such diagram, the main amplifier is represented by the current generator designated by "$I_{Main}$", while the auxiliary amplifier is represented by the current generator designated by "$I_{Aux}$". Between the "$I_{Main}$" generator and the "$Z_{Load}$" circuit load, where the amplified power is transferred, an impedance inverter, "-jk", with characteristic impedance "k", is placed.

If the following dimensioning of the circuit is provided:

$$K = Rl_{Opt}$$

(where $Rl_{Opt}$ is the optimal load impedance of the main amplifier, dimensioned for the peak envelope power of the signal)

$$Z_{Load} = 1/2 * Rl_{opt}$$

$$I_{Aux} = -j * I_{Main\ max} \quad @ \quad P_{Envelope} = P_{Out\ max}$$

(this means that the current of the auxiliary amplifier must be 90° later than the maximum current of the main amplifier "$I_{Main\ max}$", when the instantaneous power of the envelope "$P_{Envelope}$" is equal to the maximum peak envelope power value "$P_{Out\ max}$")

$$I_{Aux} = 0 \ @ \ P_{Envelope} = P_{Out\ max} - 6\ dB$$

(this means the auxiliary amplifier is switched off for an instantaneous power value of less than 6 dB at the maximum peak envelope power value)

The following results are obtained:

$$Rl_{Main} = Rl_{Opt} \ @ \ P_{Envelope} = P_{Out\ max}$$

$$(I_{Main} = I_{Main\ max})$$

(where $RI_{Main}$ is the load impedance of the main amplifier)

$$RI_{Main} = 2*RI_{Opt} @ P_{Envelope} = P_{Out\,max} - 6\,dB$$

$$(I_{Main} = I_{Main\,max} / 2)$$

In this manner the voltage "$V_{Main}$" at the terminals of the main amplifier remains almost constantly at the maximum value for a dynamic of 6 dB of reduction in power, thus ensuring optimal efficiency in such range of dynamic excursion of the power of the envelope of the amplified signal. It is in fact known that the condition of maximum efficiency of a class-AB amplifier corresponds to the condition of maximum value of the output signal voltage. This means that, by modulating the load impedance of the main branch of the circuit so as to ensure an output voltage almost constantly at the maximum permitted value for a decrease of 6 dB of the instantaneous envelope power, efficiency is maximized for a dynamic range of as much as 6 dB. Such behavior in fact ensures a considerable increase in the overall efficiency of an amplifier dedicated to the amplification of signals modulated with a complex envelope, which is typical of all modulations that take advantage of wide variations in envelope amplitude.

The purpose of the impedance inverter "-jk", in Figure 1, is to ensure the correct load impedance of the main circuit and of the auxiliary circuit, when they are operating balanced, or almost, at the maximum envelope power, while it has to double the load impedance of the main circuit in the "6 dB back-off' condition, at which point the auxiliary circuit is switched off, such circuit being therefore nonlinear, in that it begins to amplify the input signal, i.e. it is switched on, only starting from -6 dB back-off, i.e. only when the input signal level exceeds -6 dB relative to the peak level, in order to then rise to match the amplification of the main circuit upon reaching the maximum peak, i.e. at 0 dB back-off, considering that the auxiliary circuit when switched off is equivalent to an open circuit.

By implementing the impedance inverter with a quarter-wave transmission line at the frequency $f_0$, the desired operation of the circuit is obtained only for a restricted frequency band, centered around the frequency $f_0$: the transmission line quickly diverges from the ideal impedance inverter behavior when the operating frequency of the amplifier diverges from the ideal frequency $f_0$.

Figure 2 shows the gain in efficiency owing to the use of the Doherty principle, with respect to a conventional class-AB amplifier. Such figure refers to a real-world application, which takes account of the physical limitations of amplification devices, which limit the maximum efficiency of the class-AB amplifier to a value lower than the theoretical maximum (78%).

The actual efficiency curve of a class-AB amplifier as the power decreases from the maximum peak value (0 dB) is shown with a thick line in Figure 2. The efficiency curve of a Doherty amplifier (based on the same technology as the benchmark class-AB amplifier) is shown with a thin line in Figure 2. Note that, even in the real-world case, the efficiency of the Doherty amplifier is kept almost constantly at values proximate to the maximum for a dynamic of over 6 dB of power decrease with respect to the maximum value. Moreover, the efficiency curve of the Doherty amplifier is always kept above that of a conventional class-AB amplifier.

The end result is that the power consumption of the power supply of a Doherty amplifier, when used for amplifying complex modulation signals, in particular with high amplitude modulation content, is far lower than that of a class-AB amplifier, typically offering a reduction in consumption proximate to 50%.

Against such advantages, there is a considerable drawback in the implementation of an effective impedance inverter. The main limitation of such application concerns the useful frequency bandwidth in which the behavior of the impedance inverter is acceptable and does not lead to excessive compromises in terms of efficiency and robustness of the amplification structure.

In practice, the use of the Doherty amplification technique is limited to amplifiers with a narrow relative band "$B_\%$", typically less than 5%, where the term "relative band" refers to the following definition:

$$B_\% = 2* (f_{Max} - f_{Min}) / (f_{Max} + f_{Min})$$

i.e. to the ratio between the bandwidth of the amplifier and the central frequency of the band.

The main limitation is due to the type of impedance inverter which is generally used for such applications, based on the use of a quarter-wavelength transmission line, of suitable characteristic impedance (corresponding to the optimal load impedance of the main amplifier "$RI_{Opt}$").

The typical Doherty power amplifier in fact has the circuits of the main and auxiliary amplifiers balanced in maximum power and coupled by way of a power inverter implemented with a quarter-wave line of characteristic impedance equal to the optimal load value of the main amplifier, and of double the general load of the main amplifier. The quarter-wave line can be moved from the circuit of the main amplifier to the circuit of the auxiliary amplifier, in particular if the output impedance of the auxiliary circuit when switched off is comparable to a short-circuit. Such variation of the layout of the circuit however has no influence on the behavior of the Doherty amplifier, or on the performance levels required of the impedance inverter which, whether it be placed in the circuit of the main amplifier, or placed in the circuit of the auxiliary amplifier, maintains the same function and the same drawback of behavior with regard to frequency.

Such structure is the general basis of all existing applications and it has an optimal behavior in a narrow frequency band, centered at the central frequency with which the piece of line, the function of which is to act as impedance inverter, assumes the electrical length of exactly 90° (a quarter-wave). In diverging a little from the central frequency, there is a degradation in performance (efficiency, but also the maximum delivered power), owing to the imperfect coupling of the two circuits, main and auxiliary, caused by the fact that the line portion, which is used to implement the impedance inversion function, behaves increasingly less like an ideal impedance inverter the more it diverges from the central frequency.

The behavior of the impedance inverter based on a line in propagation, equal to a quarter-wave with respect to the central frequency of the application, is effective with a narrow band, thus limiting the corresponding useful band to values less than 5%. Within this frequency variation, the performance compromise (degradation of efficiency and of delivery) can be considered acceptable, as well as controllable, during testing. If a wider band is used, we enter a zone where the variations in behavior of the line, owing to the non-ideal behavior as an impedance inverter, become very significant, with consequent difficulty in controlling the performance and risk of breaking the devices in the amplifier.

The amplitude of the band of a Doherty amplifier is currently the main limitation of the application, which conditions its use in applications in which wide-band amplifiers are needed, such as, for example, in transmitters for broadcasting or for the new requirements of broadband wireless transmission.

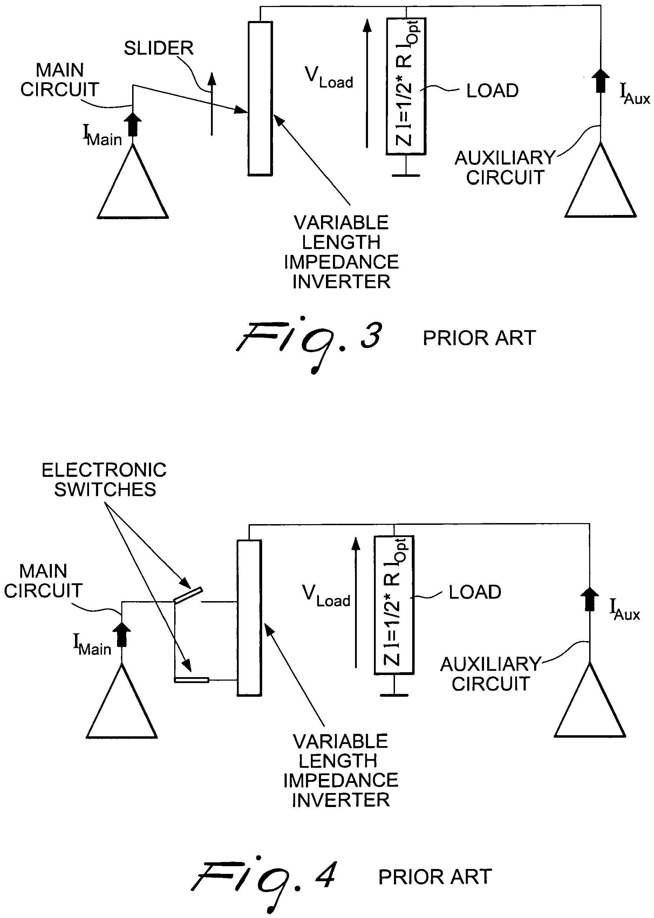

In order to seek to overcome the above mentioned application limits, variations are currently known of the Doherty amplifiers, shown in Figures 3 to 6.

Figure 3 shows a diagram of a mechanical solution for modifying the length of the quarter-wave line as a function of the frequency of use of the amplifier, in order to best adapt it to the variations in operating frequency. Substantially a slider is provided that varies the effective length of the line that provides the impedance inversion. However such variation is merely mechanical and requires a delicate manual operation.

Figure 4 shows a diagram of a more refined solution to the previous problem, implemented by using electronic switches, typically PIN diodes (from the acronym "P-type, Intrinsic, N-type"), for varying the effective length of the transmission line adapted to provide the impedance inverter. Figure 4 shows a simple schematization of the electronic switches adapted to vary the effective length of the impedance inverter.

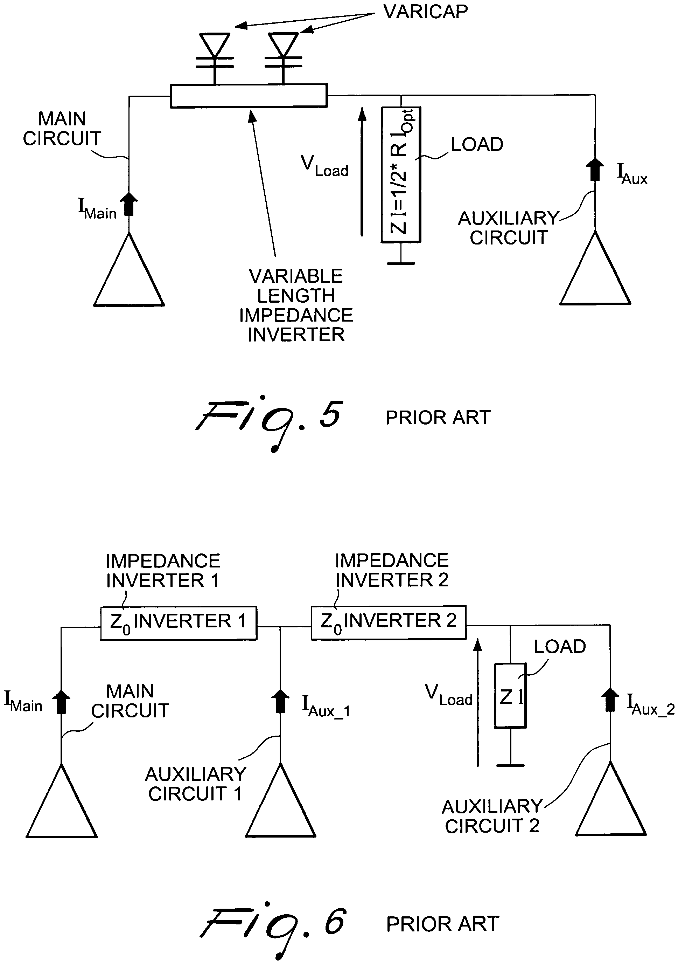

Figure 5 shows a diagram of a similar solution to the previous problem, provided by using diodes of the "varicap" type, i.e. electronically controlled variable condensers, to vary the effective length of the transmission line adapted to provide the impedance inverter. Figure 5 shows a simple schematization of the "varicap" diodes adapted to vary the effective length of the impedance inverter and also to modulate its characteristic impedance.

The provision of electronic switches or of varicap diodes is critical, because these must act on the path of the radiofrequency signal without creating unwanted variations in the characteristic impedance of the line that provides the impedance inversion, or nonlinearity distortions of the signal in transit. This often requires the use of components that are very critical and difficult to control, especially as the power of the application increases.

The implementation based on such principles can be much more complex than the simple schematization in Figures 4 and 5, especially when a greater number of switches or a greater number of varicap diodes is used, and the path of the impedance inversion line is complex.

Alternatively the use is also commonly known of Doherty structures with a greater number of auxiliary circuits which are gradually switched on at different levels of envelope power, in order to boost the dynamic of the Doherty principle and at the same time widen the effective band of the application.

Figure 6 shows a Doherty amplifier with 3 devices, or 3 circuits, where, substantially, the Doherty amplifier constituted by the main circuit together with the first auxiliary circuit, which are connected by the first impedance inverter "$Z_0$ inverter 1", becomes in turn the main circuit of the overall Doherty circuit, provided with the connection, by way of the second impedance inverter "$Z_0$ inverter 2", to the overall load "Z1" and to the second auxiliary circuit, which acts as the auxiliary circuit of the overall structure.

Similarly it is possible to increase the number of devices, and thus of circuits, by providing complex Doherty structures.

By taking advantage of such complexity it is possible to extend the maximum efficiency dynamic to over 9 dB. Such extension to a plurality of circuits can also be exploited in order to slightly increase the frequency band of the Doherty amplifier thus provided.

In Doherty amplifiers with three or more circuits, however, the complexity of the circuits and the difficulty of implementation increase considerably.

The aim of the present invention consists in providing a power amplifier with a modified Doherty topology that solves the above mentioned technical problems, eliminates the drawbacks and overcomes the limitations of the known art, by making it possible to ensure uniform and optimal performance levels on a relatively wide frequency band.

Another object of the invention consists in providing a Doherty amplifier that has a wide useful frequency band.

Another object of the invention consists in providing a Doherty amplifier that has optimal efficiency also in the amplification of signals with a complex envelope and digitally modulated.

Another object of the invention consists in providing a Doherty amplifier that reduces consumption of electricity.

Another object of the invention consists in providing a Doherty amplifier that is capable of offering the widest guarantees of reliability and safety in use.

Another object of the invention consists in providing a Doherty amplifier that is easy to implement and economically competitive when compared to the known art.

This aim and these and other objects which will become better apparent hereinafter are achieved by a power amplifier with a modified Doherty topology adapted to drive a load, comprising a main circuit in turn comprising a main amplifier, and an auxiliary circuit in turn comprising an auxiliary amplifier, **characterized in that** it comprises a circuit with paired transmission lines which is adapted to connect said main circuit to said auxiliary circuit.

Further characteristics and advantages of the invention will become better apparent from the description of a preferred, but not exclusive, embodiment of a power amplifier with a modified Doherty topology, illustrated by way of non-limiting example in the accompanying drawings, wherein:

Figure 1 is a schematic diagram of a conventional Doherty power amplifier;

Figure 2 is an illustrative chart of the efficiency of a conventional Doherty power amplifier, compared with the efficiency of a known class-AB amplifier;

Figure 3 is a schematic diagram of a conventional Doherty power amplifier with a mechanical variation of the length of the quarter-wave line of the impedance inverter;

Figure 4 is a schematic diagram of a conventional Doherty power amplifier with electronic switches for selecting the length of the quarter-wave line of the impedance inverter;

Figure 5 is a schematic diagram of a conventional Doherty power amplifier with electronically controlled variable condensers for varying the length of the quarter-wave line of the impedance inverter;

Figure 6 is a schematic diagram of a conventional Doherty power amplifier with a plurality of circuits;

Figure 7 is a schematic diagram of an embodiment of a power amplifier with a modified Doherty topology, according to the invention;

Figure 8 is a more detailed schematic diagram of the embodiment of the invention shown in Figure 7;

Figure 9 is an illustrative chart of the adaptation of the load impedance of the main circuit of the Doherty amplifier in Figure 7, according to the invention, compared with the adaptation of the load impedance of the main circuit of a conventional Doherty amplifier.

With reference to the figures, the power amplifier with a modified Doherty topology, generally designated with the reference numeral 1, is adapted to drive a load 4 and comprises a main circuit 2 in turn comprising a main amplifier 20, and an auxiliary circuit 3 in turn comprising an auxiliary amplifier 30.

According to the invention, the power amplifier 1 comprises a circuit 5 with paired transmission lines 57, 58 that connects the main circuit 2 to the auxiliary circuit 3. The circuit 5 with paired transmission lines, also known as a "4-port inverter", implements an impedance inverter.

The term "circuit with paired transmission lines" generically means a pair of transmission lines, not isolated from each other by electromagnetic screening, which thus share the propagation space and, as a consequence, undergo the mutual interaction of the electromagnetic fields transported thereby. Such interaction consists in the continuous mutual exchange of electromagnetic energy between the two lines along the propagation path. Such phenomenon is conveniently exploited in order to remove the desired quantity of power from a transmission line in favor of a second, conveniently paired line, but also, dually, to add together the power contributions of two lines. In fact the circuit with paired lines is configured as a mutual electromagnetic circuit with four ports that physically coincide with the ends of the paired lines, which can be connected to other parts of the circuit by way of additional transmission lines, isolated from each other, which run from the four ends.

The circuit 5 with paired transmission lines can be connected to an inversion impedance 6 in order to provide such impedance inverter. Advantageously such inversion impedance 6 is a pure reactance, therefore with no losses.

The paired transmission lines 57, 58 of the circuit 5 comprise a pair of transmission lines, where the first of said transmission lines 57 connects the main circuit 2 to the inversion impedance 6, while the second of said transmission lines 58 connects the auxiliary circuit 3 to the load 4.

## EP 2 621 084 A1

The circuit 5 advantageously comprises four output ports 52, 53, 54, 56, where the first port 52 is connected to the main circuit 2, the second port 53 is connected to the auxiliary circuit 3, the third port 54 is connected to the load 4, and the fourth port 56 is connected to the inversion impedance 6.

The ports 54 and 53 are galvanically connected by the line 58, just as the ports 52 and 56 are galvanically connected by the line 57. In particular when the electrical length of the paired lines is equal to 90° to the frequency of use, with suitable approaching of the lines 57 and 58 it is possible to ensure that the input power at the ports 52 and 53 are added together, converging on the port 54, while nothing goes to the port 56 (assuming that the input signals have the same amplitude and that the input signal to the port 53 is 90° later with respect to the input signal to the port 52). By distancing the lines 57 and 58 the coupling is varied, and the portion of power that is sent to the port 54 can be modified, while still keeping the power on the port 56 null (a phenomenon known as directivity).

Of particular interest is the phenomenon of adding of signals of equal amplitude, which is widely exploited in radiofrequency and microwave circuits. The relevant property of the paired lines is that they can make two generators, or amplifiers, interact in an additive manner, i.e. the main amplifier 20 and auxiliary amplifier 30, which inject power to the ports 52 and 53. If the injected power values are of equal amplitude and conveniently balanced, they are added together on the port 54 (and nothing goes to the port 56). If the power values become unbalanced, then part of the power also goes to the port 56. For this reason it is important to terminate such port properly.

In order to obtain the adder and impedance inverter, which is the subject matter of the study, the value of the impedance 6 for closing the port 56 is thus important as well. When the generators are balanced, their contributions are added in output at the port 54. When the generators are unbalanced, i.e. the auxiliary circuit 3 of port 53 is switched off, the inversion impedance, i.e. the termination of the port 56, intervenes to determine the desired variation of load impedance of the main circuit 2 at the port 52.

The power amplifier with a modified Doherty topology 1 can comprise a plurality of auxiliary circuits, according to the structure in Figure 6, which are connected with impedance inverters implemented with the paired lines technique of the circuit 5 and with the use of the inversion impedance 6.

The power amplifier with a modified Doherty topology 1 can further comprise mechanical means, or electronic switches, or electronically controlled variable condensers, for varying the length of the impedance inverter such as those in Figures 3, 4 and 5, belonging to the known art.

Operation of the power amplifier with a modified Doherty topology is described below.

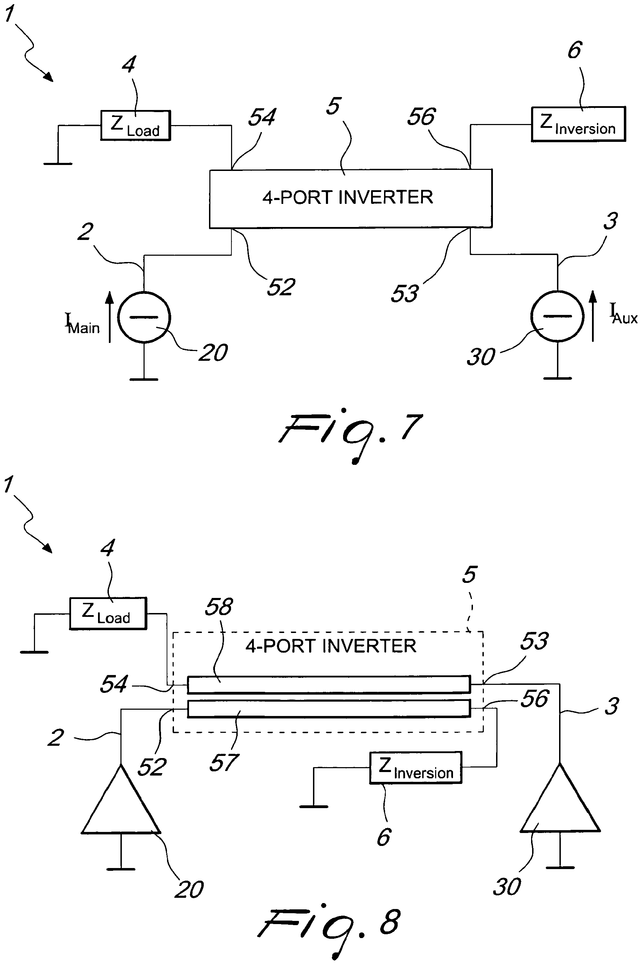

As can be seen in the schematic diagram in Figures 7 and 8, the classic topology of the Doherty amplifier is revised, with the addition of a circuit 5 with four ports 52, 53, 54 and 56, which couples the two circuits, main 2 and auxiliary 3, of the amplifier 1.

Such circuit 5 moreover doubles the load impedance of the main circuit 2, when the auxiliary circuit 3 is switched off, in the "6db back-off' condition with respect to the maximum signal peak.

In addition the circuit 5 provides all the active power, generated by the main 2 and auxiliary 3 circuits, to the load 4.

The operation of a conventional Doherty amplifier, such as that schematized in Figure 1, corresponds in part to the operation of the power amplifier with a modified Doherty topology 1, according to the invention. When the main 2 and auxiliary 3 circuits are at maximum envelope power and are balanced in power, their contributions are added to the load 4 and each one of the two circuits 2 and 3 sees the optimal load. In the "6 dB back-off' condition with respect to the maximum envelope power, the auxiliary circuit is switched off and the main circuit sees a doubling of the load impedance (condition of maximum efficiency in the event of the output current being halved). In practice in both cases the Doherty effect is replicated.

In the power amplifier with a modified Doherty topology 1, the effect of doubling the load impedance of the main circuit (when the auxiliary circuit is switched off due to the "6 dB back off' condition) is kept valid for a sufficiently wide frequency band.

According to the invention the two circuits, main 2 and auxiliary 3, of the amplifier 1 are coupled by way of the circuit 5, there no longer being present a physical electrical node at which the two circuits 2 and 3 and the load 4 physically converge.

The characteristic parameters of the circuit 5 are:

- Characteristic impedance of the paired transmission lines 57, 58;
- Coupling factor of the paired transmission lines 57, 58;
- Electrical length of the paired transmission lines 57, 58.

Correct dimensioning of the parameters listed above, together with the dimensioning of the inversion impedance 6, of the purely reactive type, makes it possible to achieve the operation according to the Doherty principle for much wider frequency bands than in the application of the quarter-wave line.

Below is a numeric example of application of such dimensioning. Such example relates to an amplifier 1 having the following technical characteristics:

- load 4 is 50 ohm (standard value for radiofrequency and microwave);
- auxiliary circuit 3 switched off and assimilated with an ideal open circuit;
- inversion impedance 6 of capacitive type, constituted by an ideal condenser of value 18pF;
- example frequency band from 600 to 800 MHz;
- characteristic impedance of the paired lines is 50 ohm, obtained with the dimensioning of the paired lines in order to have the even characteristic impedance parameters of the value of 120 ohm and odd characteristic impedance parameters of the value of 21 ohm, and electrical length equal to 90° at 700 MHz.

In such case an optimal approximation is obtained of doubling of the load impedance of the main circuit ($Z_{Load}$ = 100 ohm) for a band greater than or equal to 200 MHz. The comparison is with the conventional application in Figure 1, where the impedance inverter is a transmission line of quarter-wave electrical length (at 700 MHz) and of theoretical impedance of 70.7 ohm, i.e. such as to give the best approximation of doubling of the impedance for such type of mains electricity supply.

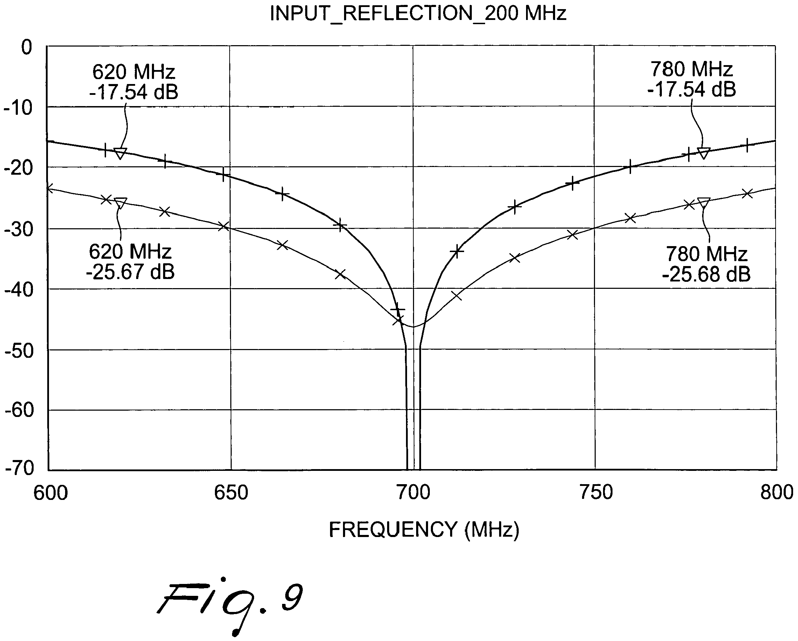

The advantage in terms of performance of the power amplifier with a modified Doherty topology 1, compared to a conventional Doherty amplifier, which avails of a quarter-wave line impedance inverter, both dimensioned as indicated, is shown in the chart in Figure 9, where an example can be seen of the degree of approximation of doubling of the impedance obtained with the "4-port inverter" circuit 5 (line with "X" markings) compared to the degree of approximation obtained with a quarter-wave line impedance inverter belonging to the known art (line with "+" markings).

The horizontal axis of the chart corresponds to the frequency in MHz (centered at 700 MHz), while the vertical axis indicates the adaptation of the load impedance of the main circuit with respect to the desired optimal value of 100 ohm.

The lower the impedance inversion error with the varying of the frequency, the more the effective band of the Doherty amplifier increases. In particular the impedance inversion error becomes particularly acute, for a quarter-wave line, for a band of 100 MHz centered at 700 MHz, while with the "4-port inverter" circuit 5 the error remains acceptable and under control even for a band of 200 MHz, again centered at 700 MHz.

The scale is logarithmic and the optimal values expected for a good implementation of the Doherty effect must be lower than -23 dB. This is true for the "4-port inverter" circuit 5 over the whole band of observation and beyond, while for the conventional impedance inverter it is true within a band slightly larger than 100 MHz, but with a very accentuated resonance and, as a consequence, a considerable sensitivity to the circuit parameters as well.

A further advantage of the "4-port inverter" circuit 5 is in the adding of the two branches of the circuit, which is much simpler and more effective than in a Doherty circuit with a quarter-wave line.

In practice it has been found that the power amplifier with a modified Doherty topology, according to the present invention, achieves the intended aim and objects in that it makes it possible to ensure uniform and optimal performance levels on a relatively wide frequency band.

Another advantage of the power amplifier with a modified Doherty topology, according to the invention, consists in that it ensures high efficiency on a relatively wide frequency band.

Another advantage of the power amplifier with a modified Doherty topology, according to the invention, consists in that it does not require manual, and therefore delicate and instable, calibration operations.

A further advantage of the power amplifier with a modified Doherty topology, according to the invention, consists in that it limits maladjustments and variations of impedance or nonlinearity distortion typical of some solutions in the known art.

Another advantage of the power amplifier with a modified Doherty topology, according to the invention, consists in that it is simple to produce.

A further advantage of the power amplifier with a modified Doherty topology, according to the invention, consists in that it limits the effects of resonance and reduces the sensitivity of the performance to the circuit parameters.

The power amplifier with a modified Doherty topology thus conceived is susceptible of numerous modifications and variations all of which are within the scope of the appended claims.

Moreover, all the details may be substituted by other, technically equivalent elements.

In practice the materials employed, provided they are compatible with the specific use, and the contingent dimensions and shapes, may be any according to requirements.

Where the technical features mentioned in any claim are followed by reference numerals and/or signs, those reference numerals and/or signs have been included for the sole purpose of increasing the intelligibility of the claims and accordingly, such reference numerals and/or signs do not have any limiting effect on the interpretation of each element identified by way of example by such reference numerals and/or signs.

**Claims**

1. A power amplifier with a modified Doherty topology (1) adapted to drive a load (4), comprising a main circuit (2) in its turn comprising a main amplifier (20), and an auxiliary circuit (3) in its turn comprising an auxiliary amplifier (30), **characterized in that** it comprises a circuit (5) with paired transmission lines (57, 58) which is adapted to connect said main circuit (2) to said auxiliary circuit (3).

2. The power amplifier with a modified Doherty topology according to claim 1, **characterized in that** said circuit (5) with paired transmission lines (57, 58) provides an impedance inverter.

3. The power amplifier with a modified Doherty topology according to claim 2, **characterized in that** said circuit (5) with paired transmission lines is connected to an inversion impedance (6) in order to provide said impedance inverter.

4. The power amplifier with a modified Doherty topology according to claim 1, **characterized in that** said paired transmission lines (57, 58) comprise a pair of transmission lines (57, 58), a first one of said transmission lines (57) connecting said main circuit (2) to an inversion impedance (6), and a second one of said transmission lines (58) connecting said auxiliary circuit (3) to said load (4).

5. The power amplifier with a modified Doherty topology according to one or more of the preceding claims, **characterized in that** said circuit (5) comprises four output ports (52, 53, 54, 56), a first port (52) being connected to said main circuit (2), a second port (53) being connected to said auxiliary circuit (3), a third port (54) being connected to said load (4), a fourth port (56) being connected to said inversion impedance (6).

6. The power amplifier with a modified Doherty topology according to one or more of the preceding claims, **characterized in that** it comprises a plurality of auxiliary circuits.

7. The power amplifier with a modified Doherty topology according to one or more of claims 2 to 6, **characterized in that** it comprises mechanical means for varying the length of said impedance inverter.

8. The power amplifier with a modified Doherty topology according to one or more of claims 2 to 6, **characterized in that** it comprises electronic switches for varying the length of said impedance inverter.

9. The power amplifier with a modified Doherty topology according to one or more of claims 2 to 6, **characterized in that** it comprises electronically controlled variable condensers for varying the length of said impedance inverter.


**Amended claims in accordance with Rule 137(2) EPC.**

1. A power amplifier with a modified Doherty topology (1) adapted to drive a load (4), comprising a main circuit (2) in its turn comprising a main amplifier (20), and an auxiliary circuit (3) in its turn comprising an auxiliary amplifier (30), and further comprising a circuit (5) with paired transmission lines (57, 58) which is adapted to connect said main circuit (2) to said auxiliary circuit (3), **characterized in that** said paired transmission lines (57, 58) comprise a pair of transmission lines (57, 58), a first one of said transmission lines (57) connecting said main circuit (2) to an inversion impedance (6), and a second one of said transmission lines (58) connecting said auxiliary circuit (3) to said load (4).

2. The power amplifier with a modified Doherty topology according to claim 1, **characterized in that** said circuit (5) with paired transmission lines (57, 58) provides an impedance inverter.

3. The power amplifier with a modified Doherty topology according to claim 2, **characterized in that** said circuit (5) with paired transmission lines is connected to an inversion impedance (6) in order to provide said impedance inverter.

4. The power amplifier with a modified Doherty topology according to claim 3, **characterized in that** said circuit (5) comprises four output ports (52, 53, 54, 56), a first port (52) being connected to said main circuit (2), a second port (53) being connected to said auxiliary circuit (3), a third port (54) being connected to said load (4), a fourth port (56) being connected to said inversion impedance (6).

5. The power amplifier with a modified Doherty topology according to one or more of the preceding claims, **characterized in that** it comprises a plurality of auxiliary circuits.

6. The power amplifier with a modified Doherty topology according to one or more of claims 2 to 5, **characterized**

**in that** it comprises mechanical means for varying the length of said impedance inverter.

**7.** The power amplifier with a modified Doherty topology according to one or more of claims 2 to 5, **characterized in that** it comprises electronic switches for varying the length of said impedance inverter.

**8.** The power amplifier with a modified Doherty topology according to one or more of claims 2 to 5, **characterized in that** it comprises electronically controlled variable condensers for varying the length of said impedance inverter.

*Fig. 1*   PRIOR ART

OVERALL EFFICIENCY OF FINAL DOHERTY STAGE

*Fig. 2*   PRIOR ART

MAIN
CIRCUIT

SLIDER

$V_{Load}$

$I_{Main}$

$Z1 = 1/2 * R1_{Opt}$

LOAD

$I_{Aux}$

AUXILIARY
CIRCUIT

VARIABLE
LENGTH
IMPEDANCE
INVERTER

Fig. 3    PRIOR ART

ELECTRONIC
SWITCHES

MAIN
CIRCUIT

$V_{Load}$

$I_{Main}$

$Z1 = 1/2 * R1_{Opt}$

LOAD

$I_{Aux}$

AUXILIARY
CIRCUIT

VARIABLE
LENGTH
IMPEDANCE
INVERTER

Fig. 4    PRIOR ART

VARICAP

MAIN CIRCUIT

$V_{Load}$

LOAD

$Zl=1/2* R l_{Opt}$

$I_{Main}$

$I_{Aux}$

AUXILIARY CIRCUIT

VARIABLE LENGTH IMPEDANCE INVERTER

*Fig. 5*     PRIOR ART

IMPEDANCE INVERTER 1

IMPEDANCE INVERTER 2

$Z_0$ INVERTER 1

$Z_0$ INVERTER 2

LOAD

$I_{Main}$

MAIN CIRCUIT

$I_{Aux\_1}$

$V_{Load}$

$Z l$

$I_{Aux\_2}$

AUXILIARY CIRCUIT 1

AUXILIARY CIRCUIT 2

*Fig. 6*     PRIOR ART

*Fig.7*

*Fig.8*

INPUT_REFLECTION_200 MHz

620 MHz
-17.54 dB

620 MHz
-25.67 dB

780 MHz
-17.54 dB

780 MHz
-25.68 dB

FREQUENCY (MHz)

*Fig. 9*

Europäisches
Patentamt

European
Patent Office

Office européen
des brevets

# EUROPEAN SEARCH REPORT

Application Number

EP 12 42 5015

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 383 883 A1 (NXP BV [NL])<br>2 November 2011 (2011-11-02)<br>* paragraph [0018] - paragraph [0021]; figure 6 *<br>* paragraph [0030] - paragraph [0031]; figures 12,13 *<br>----- | 1-3,6 | INV.<br>H03F1/02 |
| X | US 6 128 478 A (KIM KEVIN [US])<br>3 October 2000 (2000-10-03)<br>* column 3, line 18 - column 6, line 29; figures 2,3 *<br>----- | 1,6 | |
| A | US 2007/008032 A1 (KYU IREI [JP] ET AL)<br>11 January 2007 (2007-01-11)<br>* the whole document *<br>----- | 1-9 | |

TECHNICAL FIELDS
SEARCHED     (IPC)

H03F

The present search report has been drawn up for all claims

| Place of search | Date of completion of the search | Examiner |
|---|---|---|
| Munich | 25 June 2012 | Lorenzo, Carlos |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

..............................................................................

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**

EP 12 42 5015

This annex lists the patent family members relating to the patent documents cited in the above-mentioned European search report.
The members are as contained in the European Patent Office EDP file on
The European Patent Office is in no way liable for these particulars which are merely given for the purpose of information.

25-06-2012

| Patent document cited in search report | | Publication date | Patent family member(s) | | Publication date |
|---|---|---|---|---|---|
| EP 2383883 | A1 | 02-11-2011 | CN | 102237852 A | 09-11-2011 |
| | | | EP | 2383883 A1 | 02-11-2011 |
| | | | US | 2012126890 A1 | 24-05-2012 |
| US 6128478 | A | 03-10-2000 | NONE | | |
| US 2007008032 | A1 | 11-01-2007 | CN | 1893259 A | 10-01-2007 |
| | | | JP | 2007019578 A | 25-01-2007 |
| | | | KR | 20070005455 A | 10-01-2007 |
| | | | US | 2007008032 A1 | 11-01-2007 |

EPO FORM P0459

For more details about this annex : see Official Journal of the European Patent Office, No. 12/82